# FASCICULE DE BREVET EUROPEEN

(11) **EP 0 513 124 B1**
(45) Date de publication et mention de la délivrance du brevet: **16.03.1994**
(21) Numéro de dépôt: 91903535.2
(22) Date de dépôt: 25.01.1991
(51) Int. Cl.: G11C 27/02

(54) **CIRCUIT D'ECHANTILLONNAGE DE SIGNAUX ANALOGIQUES**
ABTASTSCHALTUNG FÜR ANALOGE SIGNALE
ANALOGUE SIGNAL SAMPLING CIRCUIT

(30) Priorité: 30.01.1990 FR 9001069
(43) Date de publication de la demande: 19.11.1992
(73) Titulaire: THOMSON-CSF SEMICONDUCTEURS SPECIFIQUES, 75008 Paris (FR)
(72) Inventeur: DEBROUX, Jean-François, F-38590 S.-Etienne-de-S.-Geoins (FR)
(74) Mandataire: Guérin, Michel
(86) Numéro de dépôt international: FR9100043
(87) Numéro de publication internationale: WO9111812

(56) Documents cités:
- EP-A- 0 279 993
- EP-A- 0 313 031
- FR-A- 2 134 159
- US-A- 3 706 986

## Description

L'invention concerne les circuits d'échantillonnage et blocage de signaux électriques analogiques.

Un exemple d'application pour lequel la présente invention est particulièrement concernée est le traitement de signaux électriques analogiques issus de capteurs photosensibles du type à transferts de charges, ou d'autres dispositifs à transfert de charges.

Bien que l'invention s'applique dans d'autres cas, on partira de l'exemple de signaux issus de capteurs photosensibles à transferts de charges.

Les contraintes de traitement de ces signaux sont la vitesse et la précision de mesure des signaux de ces capteurs.

Les signaux se présentent sous forme de créneaux de tension successifs séparés par des paliers à un niveau de tension de référence. Cela correspond en effet au fait que les signaux résultent de la conversion de paquets de charges photosensibles transportées par des registres à décalage. Le niveau de tension d'un créneau correspond à une quantité de charges qui représente l'éclairement d'un point. Le niveau de tension d'un créneau suivant représente l'éclairement du point suivant. Le niveau de tension du palier qui les sépare correspond à un niveau de noir.

Le niveau de noir peut varier lentement au cours d'une analyse d'image, mais il faut toujours que le niveau de signal utile des créneaux soit référencé par rapport à ce niveau de noir.

Pour pouvoir effectuer un traitement de l'image reçue point par point, il s'avère nécessaire d'échantillonner et bloquer le niveau de signal de chaque créneau aussi longtemps que possible, c'est-à-dire en pratique pendant toute la période séparant un créneau du suivant. En effet, pour traiter rapidement de nombreux points, il faut qu'ils se succèdent à cadence élevée, et on dispose donc d'un temps très court pour traiter chaque signal. Le traitement est par exemple une conversion analogique numérique.

Les contraintes de traitement de signal sont donc d'une part l'échantillonnage et le blocage du signal sur une période complète, d'autre part l'établissement d'un niveau de tension de référence fixe du signal de sortie échantillonné et bloqué, en sachant que le niveau de référence du signal d'entrée peut varier. Les autres contraintes sont la vitesse de traitement et la précision.

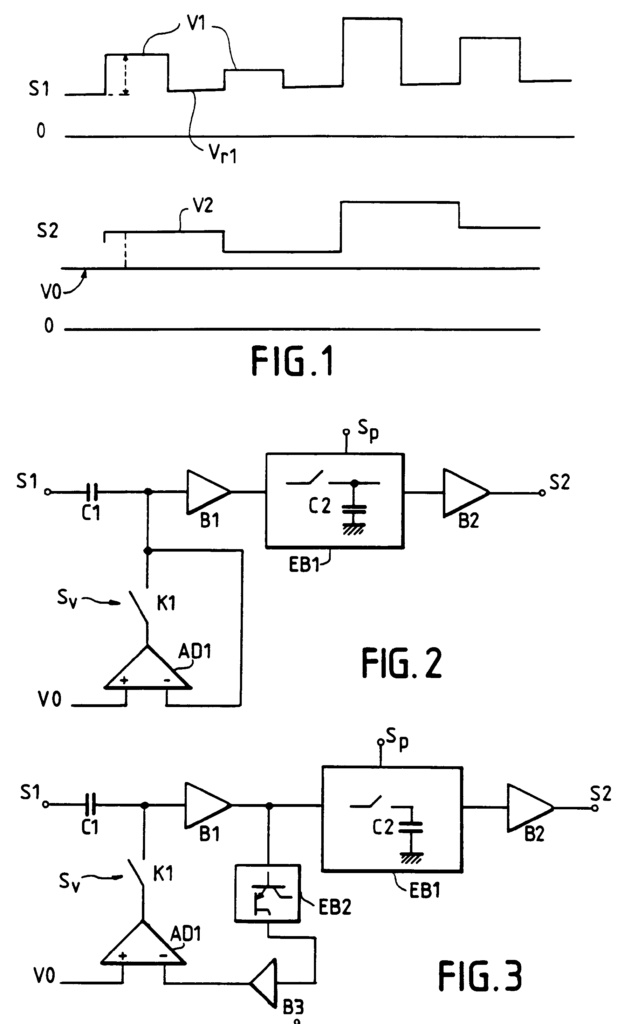

La figure 1 représente à titre d'exemple le signal d'entrée S1 en forme de créneaux avec les paliers de référence (niveau Vr1 susceptible de dériver au cours du temps) et les créneaux de signal utile V1, la valeur de signal utile étant la différence V1 - Vr1 entre le niveau du créneau et le niveau du palier juste avant ou juste après. La figure 1 représente également le signal de sortie S2 désiré, à savoir un signal échantillonné et bloqué pendant un intervalle de temps égal à celui qui sépare deux créneaux successifs du signal d'entrée. Le signal S2 est une succession de marches d'escalier de niveaux variables V2 référencés par rapport à une tension de référence fixe V0. Chaque niveau de marche V2 pris par rapport à ce niveau de référence représente le niveau de signal utile V1 pris par rapport au palier Vr1. On suppose pour simplifier que l'échantillonneur qui établit S2 a un gain unité.

Les solutions classiques utilisées pour faire cet échantillonnage sont les suivantes : l'entrée de signal peut être appliquée à une entrée d'un amplificateur différentiel, et appliquée également à une autre entrée de l'amplificateur, mais avec un retard correspondant à une demi période de signal d'entrée (retard produit par une ligne à retard). De cette manière, l'une des entrées reçoit un niveau de signal utile V1 pendant que l'autre reçoit le niveau de palier Vr1 immédiatement précédent ou suivant. La sortie de l'amplificateur est appliquée à un échantillonneur bloqueur dont la référence est la tension V0. L'échantillonneur bloqueur maintient un niveau V2-V0 égal à V1-Vr1 depuis un instant d'échantillonnage jusqu'à l'échantillonnage suivant.

Ce circuit ne fonctionne qu'à condition que la fréquence des créneaux soit bien constante, afin que le retard introduit par la ligne à retard corresponde bien à une demi période des créneaux d'entrée. Si on change de fréquence, il faut changer de ligne à retard. De plus, l'amplificateur différentiel est relativement délicat à réaliser car il doit posséder une très bonne réjection de mode commun à la fréquence du signal. Sinon on n'élimine pas la dérive des paliers de référence du signal d'entrée. Une bonne réjection de mode commun est difficile à obtenir si on doit travailler à fréquence élevée.

Une autre solution utilisée consiste à prendre deux échantillonneurs bloqueurs recevant en parallèle le signal d'entrée et échantillonnés l'un pendant les paliers de référence et l'autre pendant les créneaux correspondant au signal utile. Un amplificateur différentiel fait la différence entre les deux niveaux échantillonnés et bloqués et référence cette différence par rapport à un niveau de référence V0. Là encore, l'amplificateur doit posséder une bonne réjection de mode commun. De plus le circuit nécessite deux échantillonneurs bloqueurs, ce qui est plus coûteux.

Une solution utilisant un seul échantillonneur bloqueur a été envisagée. Elle comporte d'une part un échantillonneur bloqueur et d'autre part une boucle de verrouillage périodique de niveau de référence à l'entrée de l'échantillonneur bloqueur.

Le circuit est représenté à la figure 2. L'entrée du circuit est appliquée à travers une capacité C1 à l'entrée d'un échantillonneur-bloqueur élémentaire EB1. La sortie de l'échantillonneur bloqueur EB1 constitue la sortie S2 du circuit. On a représenté en entrée et en sortie de l'échantillonneur bloqueur EB1 des amplificateurs tampons B1 et B2 respectivement qui n'ont qu'une fonction d'adaptation d'impédance pour éviter de charger les capacités du circuit par des courants trop importants. Mais l'échantillonneur bloqueur proprement dit est constitué schématiquement par un interrupteur suivi d'une capacité. L'interrupteur permet, lorsqu'il est fermé pendant un instant d'échantillonnage, de charger la capacité au niveau de tension appliqué à l'entrée de l'échantillonneur. L'échantillonnage a lieu pendant les créneaux de signal utile.

Une boucle de verrouillage de niveau de palier de référence est prévue. Elle est représentée symboliquement sur la figure 2. Elle comprend un amplificateur différentiel AD1 dont une entrée est reliée à une tension de référence V0; une autre entrée est reliée à la sortie de l'amplificateur; cette sortie est reliée, par l'intermédiaire d'un interrupteur K1, à l'entrée de l'échantillonneur bloqueur EB1 (soit devant soit derrière B1). L'interrupteur est fermé périodiquement par un signal de verrouillage Sv (qui est émis pendant les paliers de référence du signal d'entrée et non pendant les créneaux utiles).

Le circuit fonctionne de la manière suivante : le signal de verrouillage établit, par bouclage de l'amplificateur AD1, le niveau de tension de référence V0 sur l'entrée de l'échantillonneur. Comme le signal de verrouillage Sv est appliqué alors que le signal d'entrée est à son palier Vr1, la capacité C1 se charge à la tension V0 - Vr1.

A la fin du signal de verrouillage, la capacité C1 garde cette charge, la boucle de verrouillage étant déconnectée (ouverture de K1) de l'entrée de l'échantillonneur bloqueur. Le signal d'entrée appliqué ensuite à l'échantillonneur bloqueur est alors le signal utile V1 auquel il faut ajouter la tension due à la charge de la capacité. Le signal appliqué à l'échantillonneur bloqueur est donc V1 - Vr1 + V0. C'est un signal représentant le niveau utile du créneau par rapport au palier, mais référencé par rapport à V0.

C'est ce niveau qui est échantillonné dans la capacité C2 de l'échantillonneur bloqueur EB1 et qui est ensuite gardé en mémoire jusqu'à l'échantillonnage suivant. La capacité C2 a une extrémité de référence connectée par exemple à une masse de potentiel zéro. L'échantillonnage suivant sera précédé d'une nouvelle étape de verrouillage du palier d'entrée par rapport à la tension de référence V0.

En d'autres mots, si le signal utile est égal au palier de référence, quel que soit le niveau du palier de référence puisque celui-ci peut varier, le signal échantillonné sera égal à V0. Si le signal utile est différent du niveau de référence, la différence sera rajoutée à V0 dans le signal échantillonné.

L'avantage est qu'il n'est pas nécessaire de réaliser un amplificateur différentiel de caractéristiques poussées. Il n'y a pas en effet de problème de réjection de mode commun puisque cet amplificateur ne reçoit qu'un signal d'erreur.

Un autre avantage est que le signal de sortie peut être référencé par rapport à une tension V0 non nulle (c'est-à-dire non égale à la tension par rapport à laquelle la capacité C2 de l'échantillonneur bloqueur est chargée). Dans ce cas par exemple, le niveau de référence V0 peut être choisi en fonction du zéro du convertisseur analogique numérique qu'on trouvera souvent en aval du circuit d'échantillonnage.

Une difficulté de réalisation pratique du schéma de la figure 2 résulte du fait que l'échantillonneur bloqueur EB1 risque d'introduire lui-même un décalage de tension, dû notamment aux jonctions des transistors qui le composent (par exemple dans le cas de réalisations en technologie bipolaire). Pour éviter cela, il serait possible de prévoir que la sortie rebouclée de l'amplificateur différentiel (et l'entrée correspondante) est reliée à la sortie de l'échantillonneur bloqueur EB1 et non à son entrée. Pendant le signal de verrouillage, la capacité d'entrée C1 se charge alors à une valeur telle que la sortie soit bien V0 pendant le palier. Mais cela oblige à prévoir un échantillonnage supplémentaire pendant le palier de référence d'entrée, pour pouvoir effectuer le verrouillage de niveau pendant ce palier. Or on souhaite au contraire que le blocage du signal utile dure aussi longtemps que possible, c'est-à-dire qu'il occupe si possible toute la durée disponible entre deux créneaux de signal utile.

L'invention propose un nouveau circuit d'échantillonnage blocage permettant d'obtenir un compromis aussi satisfaisant que possible par rapport à l'ensemble des contraintes pesant sur ce type de circuit et notamment les contraintes qui ont été exposées en détail ci-dessus.

Selon l'invention, on propose un circuit d'échantillonnage comme indiqué dans la revendication 1.

En principe, le signal d'entrée du circuit selon l'invention est appliqué à l'échantillonneur bloqueur à travers une capacité. C'est cette capacité qui va garder en mémoire une tension qui est la différence entre la tension de référence de l'amplificateur et le palier de référence du signal d'entrée, augmentée du décalage de tension introduit par les éléments de circuit de la boucle de contre réaction.

Dans une réalisation pratique, l'échantillonneur bloqueur élémentaire comprend une entrée de signal reliée à la base d'un premier transistor monté en suiveur de tension, une sortie reliée à l'émetteur de ce premier transistor, une capacité reliée à cette sortie pour mémoriser une tension de sortie entre deux instants d'échantillonnage, et une entrée de commande d'échantillonnage pour bloquer ou autoriser la conduction du transistor suiveur; les éléments de circuit introduisant un décalage de tension comprennent un deuxième transistor monté et alimenté comme le premier, la jonction base-émetteur de ce deuxième transistor étant en série dans la boucle de contre réaction.

De préférence encore, l'échantillonneur bloqueur comprend un troisième transistor en série entre l'émetteur du premier et une source de courant d'alimentation d'émetteur, la commande d'échantillonnage étant reliée notamment à la base de ce troisième transistor, caractérisé en ce que les éléments de circuit introduisant un décalage de tension comprennent un quatrième transistor en série entre l'émetteur du deuxième et une source de courant d'alimentation d'émetteur identique à la première, la base de ce transistor étant commandée de telle sorte que les courants dans les deuxième et quatrième transistors soient identiques, afin que les tensions base-émetteur des premier et deuxième transistors soient également identiques.

Les caractéristiques et avantages de l'invention apparaîtront à la lecture de la description qui suit et qui est faite en référence aux dessins annexés dans lesquels :
- la figure 1 représente des signaux d'entrée à échantillonner et des signaux de sortie échantillonnés issus par exemple d'un capteur photosensible;
- la figure 2 représente un schéma de principe d'un circuit d'échantillonnage blocage utilisant à la fois un échantillonneur bloqueur et un circuit de verrouillage de niveau de référence d'entrée;
- la figure 3 représente un schéma synoptique de l'invention;
- la figure 4 représente un schéma détaillé d'un exemple de réalisation de l'invention;

Le schéma synoptique de la figure 3 comporte une entrée de signal S1 reliée à une borne d'une capacité C1 dont l'autre borne est reliée à l'entrée d'un échantillonneur bloqueur EB1. L'échantillonneur bloqueur comprend si c'est nécessaire (ou est précédé et suivi par) des amplificateurs tampons B1 et B2 permettant d'établir des impédances d'entrée élevées empêchant la décharge des capacités qui doivent maintenir des tensions déterminées à leurs bornes.

L'échantillonneur bloqueur proprement dit comprend schématiquement un interrupteur fermé pendant un instant d'échantillonnage et ouvert pendant le temps de blocage qui suit l'instant d'échantillonnage, jusqu'à l'instant d'échantillonnage suivant. Cet interrupteur permet de charger une capacité C2 avec la tension présente à l'entrée de l'échantillonneur. A l'ouverture de l'interrupteur, la capacité C2 conserve sa charge jusqu'à l'instant d'échantillonnage suivant, dans la mesure où l'impédance d'entrée de B2 est suffisamment élevée. La capacité C2 a une borne de référence connectée par exemple à une masse électrique par rapport à laquelle toutes les valeurs de tension sont mesurées.

Le schéma comporte un circuit de verrouillage de niveau de tension de référence. Ce circuit comporte un amplificateur différentiel bouclé et a pour rôle d'établir, pendant des instants de recalage de niveau, une tension aux bornes de la capacité C1, en fonction d'un niveau de tension de référence V0 du circuit et en fonction d'un niveau de référence propre Vr1 du signal d'entrée S1. Entre deux instants de recalage successifs, la capacité C1 conserve à ses bornes cette tension de recalage de niveau.

Les instants de recalage, définis par un signal de verrouillage Sv, sont choisis pendant qu'on applique à l'entrée de signal S1 un niveau de tension correspondant au niveau de tension de référence du signal d'entrée. Dans l'exemple décrit à propos de la figure 1, où le signal utile est constitué par des créneaux séparés par des paliers correspondant au niveau de référence (éventuellement lentement variable), on établit un signal de verrouillage de niveau pendant les paliers séparant les créneaux utiles.

Le signal de verrouillage commande un interrupteur K1 servant à relier la sortie d'un amplificateur différentiel AD1 à l'entrée de l'échantillonneur bloqueur. Dans la pratique, on verra que l'interrupteur n'est pas nécessairement situé entre une sortie de l'amplificateur et l'entrée de l'échantillonneur. Dans la technologie bipolaire de fabrication des circuits intégrés, on verra en effet qu'il est plus facile par exemple de couper et remettre en service l'alimentation de l'amplificateur. Dans tous les cas, le signal de verrouillage doit agir pour connecter un circuit permettant de charger la capacité à la tension désirée puis déconnecter ce circuit pour isoler la capacité afin qu'elle ne perde pas cette charge.

L'amplificateur différentiel AD1 comporte deux entrées; une entrée non inverseuse (par exemple) est reliée à une source de tension de référence V0. Une entrée inverseuse est reliée, par l'intermédiaire d'une boucle de contre réaction, à l'entrée de l'échantillonneur bloqueur EB1.

La boucle de contre réaction comprend des éléments de circuit provoquant entre la sortie de l'amplificateur (connectée à une borne de la capacité pendant le recalage) et l'entrée inverseuse, un décalage de niveau de tension exactement égal au décalage qui est introduit par construction entre la même borne de la capacité et la sortie S2 du circuit d'échantillonnage blocage.

La sortie S2 du circuit d'échantillonnage est prise par exemple à la sortie de l'amplificateur tampon B2. Dans ces conditions, des décalages de niveau de tension peuvent être introduits par l'amplificateur tampon B1, puis par l'échantillonneur EB1, puis par l'amplificateur tampon B2.

La boucle de réaction comprend alors, entre la borne de la capacité C1 et l'entrée inverseuse de l'amplificateur AD1, la succession d'éléments suivants : d'abord l'amplificateur tampon B1 (ce pourrait être un amplificateur identique à B1, mais il est ici aussi simple de prendre B1), puis un élément de circuit EB2 provoquant le même décalage de tension que EB1, puis un amplificateur tampon B3 identique à B2 (ou tout au moins provoquant le même décalage de niveau de tension). L'élément EB2 pourra être comme on le verra un simple interrupteur à transistors analogue à l'interrupteur de l'échantillonneur EB1 mais n'ayant pas besoin de commande d'actionnement.

Avec ce schéma, le circuit d'échantillonnage blocage peut fonctionner de la manière décrite ci-après; on reprendra les mêmes notations de tension que celles utilisées à propos des figures 1 à 3, en désignant en outre par dV le décalage de niveau de tension global susceptible d'être introduit par la succession des éléments B1, EB1, et B2, ou le décalage identique introduit par la succession B1, EB2, B3.

Lors des instants de recalage définis par le signal Sv, le signal de référence est à son niveau de palier variable Vr1 et est appliqué à une borne de la capacité C1. L'amplificateur bouclé transmet, via l'interrupteur K1, une tension V0 + dV à l'autre borne de la capacité C1, la tension d'offset de l'amplificateur étant supposée négligeable. En effet, le bouclage de l'amplificateur ramène nécessairement l'entrée inverseuse de l'amplificateur à V0 pour équilibrer la tension V0 présente sur l'entrée non inverseuse; et pour q'il y ait V0 sur l'entrée inverseuse compte tenu du décalage de tension dV introduit par la boucle, il est nécessaire qu'il y ait V0 + dV sur la deuxième borne de la capacité C1.

La capacité C1 se charge donc à une tension Vr1 -V0 -dV.

Après la fin du signal Sv, la capacité reste déconnectée de l'amplificateur et ne peut pas se décharger.

Lors d'un instant d'échantillonnage du signal d'entrée utile, dont la valeur est supposée être V1, la tension effectivement transmise sur la deuxième borne de la capacité n'est pas V1 mais V1 -Vr1 + V0 +dV

L'amplificateur tampon B1, l'échantillonneur bloqueur EB1, et l'amplificateur tampon B2 introduisent un décalage de tension dV de sorte que la tension échantillonnée et bloquée qu'on retrouve en sortie de l'amplificateur B2 donc en sortie du circuit selon l'invention est V1 - Vr1 + V0. C'est donc bien la valeur désirée, qui est la différence entre le signal d'entrée utile V1 et son niveau de référence propre Vr1 éventuellement variable, cette différence étant calée sur le niveau de référence V0.

Le niveau de référence de sortie V0 peut être choisi à volonté puisque c'est le niveau qu'on applique à l'entrée d'un amplificateur différentiel. Dans le cas par exemple où le signal de sortie du circuit d'échantillonnage blocage de l'invention est utilisé comme entrée d'un convertisseur analogique numérique, on peut prendre pour niveau V0 un niveau correspondant à la valeur numérique zéro du convertisseur. Ainsi, dans un convertisseur travaillant entre -1 volt et + 1 volt avec une valeur numérique de sortie zéro pour une tension analogique d'entrée de -1 volt, on choisira de préférence V0 = -1 volt.

On va maintenant donner un exemple de réalisation détaillée montrant que si l'échantillonneur est réalisé de façon assez simple (pour être rapide) il introduit un décalage de tension que l'invention compense parfaitement.

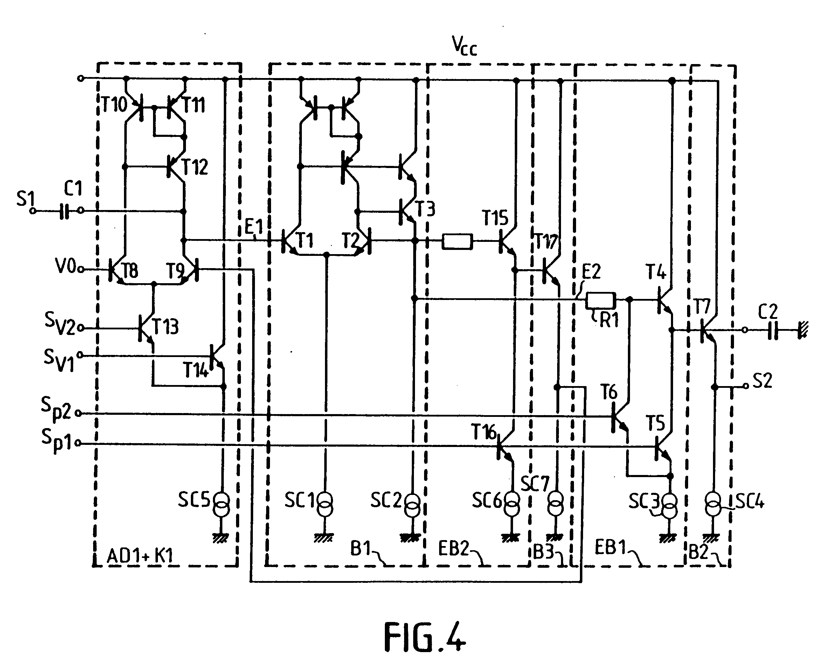

L'exemple est représenté à la figure 4.

Les blocs en traits pointillés correspondent aux fonctions générales de la figure 3 et sont désignés par les mêmes références.

L'entrée de signal S1 est reliée par une capacité C1 à l'entrée E1 d'un amplificateur suiveur B1 classiquement constitué à partir d'une paire différentielle de deux transistors T1 et T2 et d'un étage de sortie suiveur qui est un transistor T3 ayant sa base connectée au collecteur du transistor T2 et son émetteur rebouclé sur la deuxième entrée de la paire différentielle, c'est-à-dire sur la base de T2. L'entrée E1 est la base de T1. La sortie de l'étage B1 est prise sur l'émetteur de T3. La paire différentielle T1, T2 est alimentée par une source de courant SC1. Le transistor T3 est alimenté par une source SC2

La sortie de l'étage B1 est reliée à l'entrée E2 de l'échantillonneur bloqueur EB1. Ce dernier est constitué par trois transistors T4, T5, T6, une source de courant SC3, et une résistance R1. L'entrée E2 est reliée par la résistance R1 à la base du transistor T4 qui est un transistor suiveur ayant son collecteur relié à la borne d'alimentation générale Vcc du circuit. La sortie de l'échantillonneur bloqueur EB1, est prise sur l'émetteur de T4. Cette sortie est reliée par une capacité C2 à la masse. Le transistor T5 est intercalé entre le transistor T4 et la source de courant SC3. Son collecteur est relié à l'émetteur de T4, son émetteur à la source de courant (reliée par ailleurs à la masse). La base de T5 est commandée par un premier conducteur Sp1 d'une commande d'échantillonnage qui comprend deux conducteurs Sp1 et Sp2. Le deuxième conducteur Sp2 commande la base du transistor T6, dont le collecteur est relié à la base de T4 et dont l'émetteur est relié, comme l'émetteur de T5, à la source de courant SC3.

La commande d'échantillonnage se fait par l'application d'un signal différentiel entre les conducteurs Sp1 et Sp2, de manière à bloquer le transistor T6 en rendant conducteur le transistor T5 pendant l'instant d'échantillonnage. Le transistor T4 est alors conducteur et la capacité C2 peut se charger à la tension d'émetteur de T4. Pendant la durée du blocage, entre deux instants d'échantillonnage, la commande différentielle Sp1, Sp2 rend conducteurs le transistor T6 et bloque le transistor T5, ce qui bloque T4 (car son courant d'émetteur est nul, et sa tension de base inférieure à sa tension d'émetteur. La capacité C2 reste isolée par le blocage de T4 et T5 et conserve la charge échantillonnée.

Le conducteur Sp2 peut être à tension fixe, le signal différentiel étant constitué par une variation de tension du conducteur Sp1. Il est important que le transistor T5 se bloque avant que le transistor T6 ne devienne conducteur pour éviter toute fuite de la capacité C2 au début de la période de blocage suivant un instant d'échantillonnage.

L'amplificateur tampon B2 est un transistor suiveur T7 alimenté par une source de courant SC4; la sortie S2 du circuit d'échantillonnage est prise sur l'émetteur de T7. Même si l'impédance de charge sur la sortie S2 est assez faible, la présence de l'amplificateur tampon B2 empêche une décharge trop rapide de la capacité. La décharge de la capacité se fait en effet à travers la base de T7 et non directement sur l'impédance connectée à la sortie S2.

Cette structure d'échantillonneur bloqueur à trois transistors et une source de courant est intéressante car elle permet un fonctionnement très rapide. Le petit nombre de transistors utilisé et le fait qu'ils puissent tous être des transistors NPN favorise cette rapidité dans le cas de réalisations monolithiques.

Mais on peut remarquer que par rapport à la tension appliquée à l'entrée E2 de l'échantillonneur bloqueur (tension qu'on voudrait réellement échantillonner et bloquer), la tension réellement obtenue sur la sortir S2 est décalée à cause des chutes de tension introduites par la jonction base-émetteur de T4 et par la jonction base-émetteur de T7. On notera qu'il y a aussi un décalage susceptible d'être introduit entre la tension d'entrée du circuit (en S1) et la tension d'entrée de l'échantillonneur (en E2).

La boucle de verrouillage de niveau de tension de référence permet de compenser ce décalage.

Cette boucle comprend l'amplificateur différentiel AD1 et le commutateur K1 qui permet de connecter périodiquement la sortie de l'amplificateur AD1 à la capacité C1 pendant une période de recalage puis de la déconnecter pour conserver la charge de la capacité jusqu'à l'instant de recalage suivant.

Les instants de recalage sont définis par un signal de verrouillage qui est un signal différentiel reçu entre deux conducteurs Sv1 et Sv2.

Comme on l'a déjà mentionné, il n'est pas nécessaire que l'interrupteur K1 soit physiquement réalisé sous forme d'un interrupteur connecté entre une sortie de l'amplificateur et une borne de la capacité C1. Dans l'exemple représenté, réalisé en technologie bipolaire, il est plus simple de prévoir que l'interrupteur sert à interrompre le courant d'alimentation de l'amplificateur différentiel car il se trouve que cette interruption permet effectivement d'isoler la capacité C1 et de conserver la charge qu'elle a acquise pendant le signal de recalage.

C'est pourquoi, l'amplificateur différentiel comprend une structure différentielle classique avec deux transistors d'entrée T8 et T9, des transistors de charge T10, T11, T12, et une source de courant SC5 pour l'alimentation de la paire de branches différentielles.

Un transistor T13 commandé par le conducteur Sv2 permet de relier la paire différentielle à la source de courant SC5 (pendant les instants de recalage) ou au contraire de l'isoler (entre les instants de recalage). Un transistor T14, commandé par le conducteur Sv1, permet d'évacuer le courant de la source SC5 entre les instants de recalage. Il est conducteur quand T13 est bloqué et réciproquement.

L'entrée non inverseuse de l'amplificateur est constituée par la base du transistor T8; elle est connectée à une source de tension de référence V0 qui est la référence par rapport à laquelle on désire établir le signal de sortie.

L'entrée inverseuse est la base du transistor T9. Elle est connectée à l'extrémité d'une boucle de contre réaction dont l'autre extrémité est constituée par la sortie de l'amplificateur différentiel. Cette sortie est ici le collecteur du transistor T9. Cette sortie est aussi connectée à une borne de la capacité C1 (celle qui n'est pas reliée à l'entrée de signal S1). Elle est connectée par conséquent aussi à l'entrée E1 de l'amplificateur tampon B1.

La boucle de contre réaction comprend en série, à partir de cette entrée E1 : d'abord l'amplificateur tampon B1 lui-même. Puis, relié à la sortie de l'amplificateur tampon B1 (émetteur du transistor T3), un étage EB2 destiné simplement à produire un décalage de tension identique à celui qui est produit par l'échantillonneur bloqueur EB1, et enfin un étage B3 destiné à produire un décalage identique à celui de B2. Dans cet exemple, l'étage EB2 comprend une résistance R2 compensant la résistance R1 et donc de préférence identique à R1, un transistor T15 compensant l'effet du transistor T4 et de préférence identique à T4 et monté comme lui ou monté de manière à produire entre sa base et son émetteur une chute de tension identique à la chute de tension base-émetteur de T4; et un transistor T16 compensant le transistor T5 et de préférence identique à T5. Il n'est pas nécessaire de compenser le transistor T6 qui n'est conducteur que pendant les instants de blocage et non pendant les instants d'échantillonnage.

Ainsi, l'étage de simulation EB2 comprend de préférence un transistor T15 dont la base est reliée à la sortie de l'étage B1 par une résistance R2, et dont l'émetteur est relié par l'intermédiaire d'un transistor T16 à une source de courant SC6 (de préférence identique à SC3).

La sortie de l'étage EB2 est prise sur l'émetteur de T15 (comme la sortie de EB1 est l'émetteur de T4); elle est reliée à l'entrée d'un amplificateur tampon B3 simulant exactement le décalage de tension introduit par l'étage B2. L'amplificateur B3 est de préférence identique à B2 et il comprend alors un transistor T17 monté en suiveur et ayant son émetteur alimenté par une source de courant SC7. L'entrée est la base de T17; la sortie est l'émetteur de T17 et est reliée à l'entrée inverseuse de l'amplificateur différentiel AD1 c'est-à-dire à la base du transistor T9.

Bien que la réalisation décrite ci-dessus soit particulièrement avantageuse, notamment en ce qui concerne l'échantillonneur bloqueur EB1, d'autres réalisations sont possibles et il faut alors adapter la constitution du circuit en fonction des décalages de tension qu'on veut rattraper.

## Revendications

1. Circuit d'échantillonnage comprenant un échantillonneur-bloqueur (EB1) et un circuit de verrouillage de niveau (AD1, K1) pour référencer l'échantillonneur bloqueur par rapport à un niveau de tension de référence (V0), le circuit de verrouillage comprenant un amplificateur différentiel (AD1) bouclé ayant une première entrée reliée à la tension de référence (V0), une sortie reliée à une entrée de l'échantillonneur bloqueur, un interrupteur (K1) pour ouvrir et fermer périodiquement une liaison entre l'amplificateur différentiel et l'entrée de l'échantillonneur bloqueur, et une boucle de contre réaction reliant l'entrée de l'échantillonneur à une deuxième entrée de l'amplificateur, l'échantillonneur bloqueur introduisant un décalage de niveau de tension entre son entrée et la sortie du circuit d'échantillonnage, caractérisé en ce que la boucle de contre réaction entre l'entrée de l'échantillonneur bloqueur et la deuxième entrée de l'amplificateur différentiel comprend des éléments de circuit (B1, EB2, B3) introduisant le même décalage de tension que le décalage présent entre l'entrée de l'échantillonneur bloqueur et la sortie du circuit d'échantillonnage.

2. Circuit selon la revendication 1, caractérisé en ce qu'il comporte une entrée de circuit reliée à l'entrée de l'échantillonneur bloqueur par l'intermédiaire d'une capacité (C1).

3. Circuit selon l'une des revendications 1 et 2, caractérisé en ce que l'échantillonneur bloqueur comprend une entrée de signal reliée à la base d'un premier transistor (T4) monté en suiveur de tension, une sortie reliée à l'émetteur de ce premier transistor, une capacité (C2) reliée à cette sortie pour mémoriser une tension de sortie entre deux instants d'échantillonnage, et une entrée de commande d'échantillonnage pour bloquer ou autoriser la conduction du transistor suiveur, et en ce que les éléments de circuit introduisant le décalage de tension comprennent un deuxième transistor (T15) monté et alimenté comme le premier, la jonction base-émetteur de ce deuxième transistor étant en série dans la boucle de réaction.

4. Circuit selon la revendication 3, caractérisé en ce que l'échantillonneur bloqueur comprend un troisième transistor (T5) en série entre l'émetteur du premier et une source de courant d'alimentation d'émetteur, la commande d'échantillonnage étant reliée notamment à la base de ce troisième transistor, caractérisé en ce que les éléments de circuit introduisant le décalage de tension comprennent un quatrième transistor (T16) en série entre l'émetteur du deuxième et une source de courant d'alimentation d'émetteur identique à la première, la base de ce transistor étant commandée de telle sorte que les courants dans les deuxième et quatrième transistors soient identiques, afin que les tensions base-émetteur des premier et deuxième transistors soient également identiques.

## Patentansprüche

1. Tastschaltung mit einem Tast- und Haltekreis (EB1) und einem Pegelverriegelungskreis (AD1, K1), um den Tast- und Haltekreis spannungsmäßig auf den Pegel der Bezugsspannung (V0) zu beziehen, wobei der Verriegelungskreis einen rückgekoppelten Differentialverstärker (AD1) enthält, der an einem ersten Eingang die Bezugsspannung (V0) empfängt und mit einem Ausgang an einen Eingang des Tast- und Haltekreises angeschlossen ist, mit einem Unterbrecherschalter (K1), um periodisch eine Verbindung zwischen dem Differentialverstärker und dem Eingang des Tast- und Haltekreises herzustellen bzw. zu unterbrechen, und mit einer Rückkopplungsschleife, die den Eingang des Tast- und Haltekreises an einen zweiten Eingang des Verstärkers anschließt, wobei der Tast- und Haltekreis eine Spannungspegelverschiebung zwischen seinem Eingang und dem Ausgang des Tastkreises einführt, dadurch gekennzeichnet, daß die Rückkopplungsschleife zwischen dem Eingang des Tast- und Haltekreises und dem zweiten Eingang des Differentialverstärkers Schaltungselemente (B1, EB2, B3) enthält, die dieselbe Spannungsverschiebung wie diejenige einführen, die zwischen dem Eingang des Tast- und Haltekreises und dem Ausgang der Tastschaltung vorliegt.

2. Schaltung nach Anspruch 1, dadurch gekennzeichnet, daß sie mit einem Schaltungseingang an den Eingang des Tast- und Haltekreises über einen Kondensator (C1) angeschlossen ist.

3. Schaltung nach einem der Ansprüche 1 und 2, dadurch gekennzeichnet, daß der Tast- und Haltekreis einen Signaleingang, der an die Basis eines ersten Transistors (T4) in Folgeschaltung angeschlossen ist, einen Ausgang, der an den Emitter dieses ersten Transistors angeschlossen ist, einen Kondensator (C2), der an diesen Ausgang angeschlossen ist, um eine Ausgangsspannung zwischen zwei Tastzeitpunkten zu speichern, und einen Taststeuereingang enthält, um den Transistor in Folgeschaltung leitend oder nicht leitend zu steuern, und daß die Schaltungselemente, die die Spannungsverschiebung einführen, einen zweiten Transistor (T15) enthalten, der wie der erste geschaltet und gespeist wird, wobei der Basisemitterübergang dieses zweiten Transistors in Reihe in der Rückkopplungsschleife liegt.

4. Schaltung nach Anspruch 3, dadurch gekennzeichnet, daß der Tast- und Haltekreis einen dritten Transistor (T5) in Reihe zwischen dem Emitter des ersten Transistors und einer Emitterspeisestromquelle enthält, wobei die Taststeuerung insbesondere an die Basis dieses dritten Transistors angeschlossen ist, dadurch gekennzeichnet, daß die Schaltungselemente, die die Spannungsverschiebung einführen, einen vierten Transistor (T16) in Reihe zwischen dem Emitter des zweiten Transistors und einer Emitterspeisestromquelle enthalten, die der erstgenannten Quelle gleicht, wobei die Basis dieses Transistors so gesteuert wird, daß die Ströme in dem zweiten und dem vierten Transistor identisch sind, damit die Basis-Emitterspannungen des ersten und zweiten Transistors ebenfalls gleich werden.

## Claims

1. Sampling circuit comprising a sample-and-hold module (EB1) and a level-latching circuit (AD1, K1) for referencing the sample-and-hold module with respect to a reference voltage level (V0), the latching circuit comprising a looped differential amplifier (AD1) having a first input connected to the reference voltage (V0), an output connected to an input of the sample-and-hold module, a switch (K1) for periodically opening and closing a link between the differential amplifier and the input of the sample-and-hold module, and a negative feedback loop connecting the input of the sampler to a second input of the amplifier, the sample-and-hold module introducing a voltage level offset between its input and the output of the sampling circuit, characterized in that the negative feedback loop between the input of the sample-and-hold module and the second input of the differential amplifier comprises circuit elements (B1, EB2, B3) introducing the same voltage offset as the offset present between the input of the sample-and-hold module and the output of the sampling circuit.

2. Circuit according to Claim 1, characterized in that it includes a circuit input connected to the input of the sample-and-hold module via a capacitor (C1).

3. Circuit according to one of Claims 1 and 2, characterized in that the sample-and-hold module comprises a signal input connected to the base of a first transistor (T4) connected in voltage follower configuration, an output connected to the emitter of this first transistor, a capacitor (C2) connected to this output in order to store an output voltage between two sampling instants, and a sampling control input for turning off or turning on the follower transistor, and in that the circuit elements introducing the voltage offset comprise a second transistor (T15) connected and supplied like the first, the base-emitter junction of this second transistor being in series in the feedback loop.

4. Circuit according to Claim 3, characterized in that the sample-and-hold module comprises a third transistor (T5) in series between the emitter of the first and an emitter current supply source, the sampling control being connected in particular to the base of this third transistor, characterized in that the circuit elements introducing the voltage offset comprise a fourth transistor (T16) in series between the emitter of the second and an emitter current supply source identical to the first source, the base of this transistor being controlled in such a way that the currents in the second and fourth transistors are identical, so that the base-emitter voltages of the first and second transistors are likewise identical.
